# EUROPEAN PATENT APPLICATION

(11) **EP 0 676 663 A1**
(43) Date of publication of application: **11.10.1995**
(21) Application number: 94304088.1
(22) Date of filing: 07.06.1994
(51) Int. Cl.: G03B 19/16, H04N 5/225

(54) **Camera**

(30) Priority: 08.04.1994 JP 70534/94
(71) Applicant: PACIFIC CORPORATION, Tokyo (JP)
(72) Inventor: Irie, Kimiyasu, c/o Pacific Corporation, Tokyo (JP)
(74) Representative: Robson, Aidan John

(57) **Abstract**

A camera lens system to obtain a focused image of an object includes a planar body having a pinhole therein and an aspherical lens arranged on the planar body. Thanks to the pinhole and the aspherical lens, a clear picture is focused on a charge-coupled device without distortion. Moreover, a color filter is fabricated through a coating process and hence has a reduced thickness. Reduction of the number of the lenses leads to minimization of the thickness of the camera, which hence is suitable to sneak a shot.

## Description

### BACKGROUND OF THE INVENTION

The present invention relates to a camera with a reduced thickness for taking pictures of an object, and in particular, a compact camera which is suitably used as a hidden or candid camera and which includes a lens section fabricated particularly in a small size to minimize the thickness of the camera, thereby facilitating concealment of the camera. Description of the Prior Art

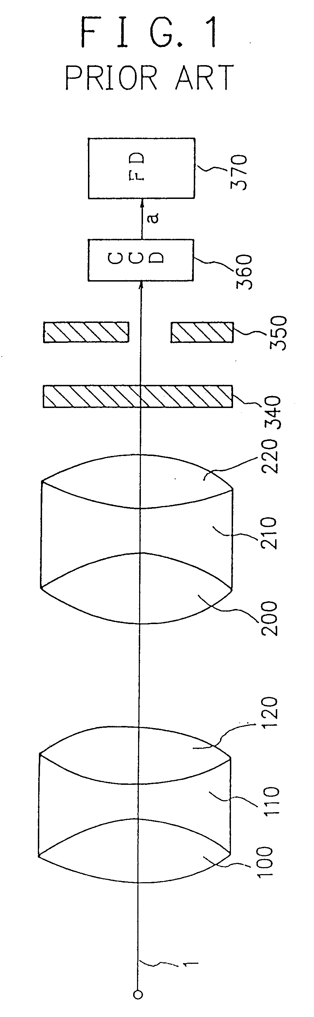

Referring now to Fig. 1, description will be given of an optical system of an example an electronic still camera according to the prior art. Fig. 1 shows in a cross-sectional view the electronic still camera along an optical axis thereof.

In this structure, a light beam 1 from an object is passed through a first group of lenses disposed in a proceeding stage of the configuration, namely, a convex lens 100, a concave lens 110, and a convex lens 12. The light 1 is further propagated through such subsequent lenses as a convex lens 200, a concave lens 210, and a convex lens 200 arranged in a succeeding stage. The light 1 is then fed through a shutter 340 and an iris 350, thereby obtaining a focused image of a still picture of the object on a charge-coupled device (CCD) 360. In the device 360, the image is transformed into an electric signal a according to the intensity of the received light. The signal a produced from the CCD 360 is thereafter written, for example, on a floppy disk (FD) 370 through a magnetic recording operation.

To attain a picture free of optical distortion, the preceding and succeeding groups of lenses are arranged in the following construction. As shown in Fig. 1, for example, the former includes the convex lens 100, the concave lens 110, and the convex lens 12, whereas the latter includes the convex lens 200, the concave lens 210, and the convex lens 200.

In the conventional camera, to attain a picture free of optical distortion as describe above, there are required the plurality of lens constitutions including, for example, the first and second groups of lenses as described above, which increases the number of lenses and hence the thickness of the camera. This resultantly leads to a problem of a high production cost.

Furthermore, the camera has the lens section exposed in the front surface thereof and hence can be readily recognized. Due to this feature as well as the disadvantageous thickness of the camera, there arises a problem that the camera is easily recognized, for example, by persons to be monitored when the camera is employed as: a monitoring camera.

Moreover, as it is difficult to miniaturize a camera, it is consequently difficult to arrange the camera on a telephone for a visual telephone, or on a conference table for a TV conference.

### SUMMARY OF THE INVENTION

It is therefore an object of the present invention to provide a low-priced compact camera with a reduced number of lenses and a simple lens structure.

Another object of the present invention is to provide a hidden camera which, when used as a monitoring camera, cannot be easily recognized by persons to be monitored.

In accordance with the embodiment of the present invention, there is provided a camera including a planar body having a pinhole disposed therein and a lens disposed on the planar body.

An aspherical lens may be employed for the lens of the camera in accordance with the present invention.

A camera for producing a color picture and embodying the present invention includes a color filter formed as a coating layer through a MgF₂ coating process on an IR glass in a position following the aspherical lens.

Moreover, the camera in accordance with the present invention includes imaging means for receiving a light passed through the pinhole and the aspherical lens and thereby producing a video signal therefrom.

### BRIEF DESCRIPTION OF THE DRAWINGS

The objects and features of the present invention will become more apparent from the consideration of the following detailed description taken in conjunction with the accompanying drawings wherein:
Fig. 1 is a cross-sectional view showing a portion of an example of a conventional camera;
Fig. 2 is a partially cut-away cross-sectional view showing a color filter of the camera of Fig. 1;
Fig. 3 is a cross-sectional view showing a portion of an embodiment of a compact camera in accordance with the present invention;
Fig. 4 is a cross-sectional view showing an alternative embodiment of a compact camera in accordance with the present invention; and
Fig. 5 is a partially cut-away cross-sectional view showing a color filter of the camera of Fig. 4.

### DESCRIPTION OF THE PREFERRED EMBODIMENTS

Referring now to the drawings, description will be given of embodiments of a compact camera in accordnace with the present invention.

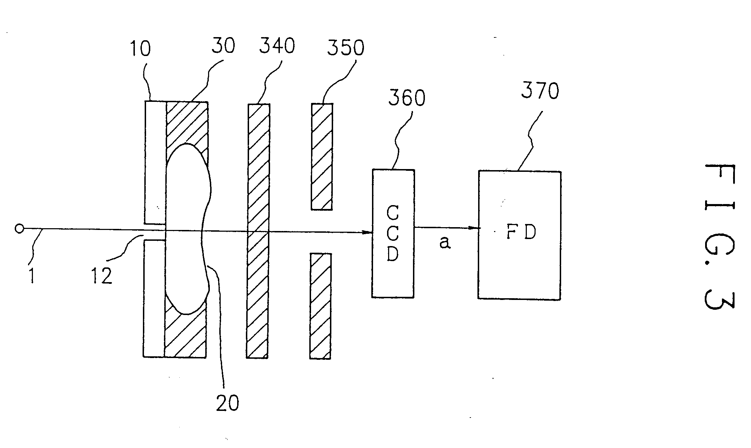

Fig. 3 shows in a cross-sectional view of an electronic still camera in an embodiment in accordance with the present invention. The cross section is taken along an optical axis of the still camera.

In the constitution of the embodiment of Fig. 3, there are missing the first and second groups of lenses 100, 110, 120, 200, 210, and 220 of Fig. 1. The camera includes a planar body 10 having a pinhole 12 bored therein and an aspherical lens 20 to receive a light beam 1 from an object. The light 1 is passed through the pinhole 12 and the aspherical lens 20. The lens 20 disposed on the rear side of the planar body 10 has a peripheral portion fixedly retained by a supporting member 30.

The configuration further includes a shutter 340 on the rear side of the lens 20. Only when shooting an object to produce a still picture thereof, the shutter is instantaneously opened, namely, is set to an open state and is then closed. In other situations, the shutter is kept closed. The shutter 340 is followed by an iris 350 and a charge-coupled device (CCD) 360 in this sequence. The shutter 340 is automatically or manually operated to adjust the quantity of light incident to the charge-coupled device (CCD) 360. The optical image fed to the CCD 360 is converted according to the intensity of the light thereof into an electric signal a. The CCD 360 has an output port connected to a floppy disk (FD) 370. Consequently, the electric signal a from the CCD 360 is magnetically written on the floppy disk 370.

Operation of the configuration above will be now described.

A light beam 1 from the object is delivered through the pinhole 12 of the planar body 10 and then the aspherical lens 20 onto the CCD 360, thereby creating an image of the object thereon. In this structure, the aspherical lens 20 succeeding the pinhole 12 adjusts refraction of the incident light along the light path to focus on the CCD 360 a clear picture of the object free of distortion.

In an operation to take a picture of an object, the shutter 340 is rapidly opened and is then closed while adjusting the quantity of light incident to the CCD 360 by the iris 350 so as to obtain an appropriate image of the object on the CCD 360. In response thereto, the CCD 360 transforms the received optical image into an electric signal a to be magnetically recorded on the floppy disk 370.

When it is desired to reproduce the still image thus written on the floppy disk 370, it is only necessary to install the disk 370 in a picture reproducing apparatus, for example, a floppy disk drive (FDD) of a personal computer (PC). The reproduced picture is then presented on, for example, a cathode-ray tube (CRT) screen thereof.

In the above embodiment, the aspherical lens 20 is employed. However, a circular lens can be replaced with the aspherical lens 20. In this connection, the embodiment includes the shutter 340 and the iris 350. However, arranging the CCD 360 at a position in the vicinity of the aspherical lens 20, the shutter 340 and the iris 350 may be dispensed with.

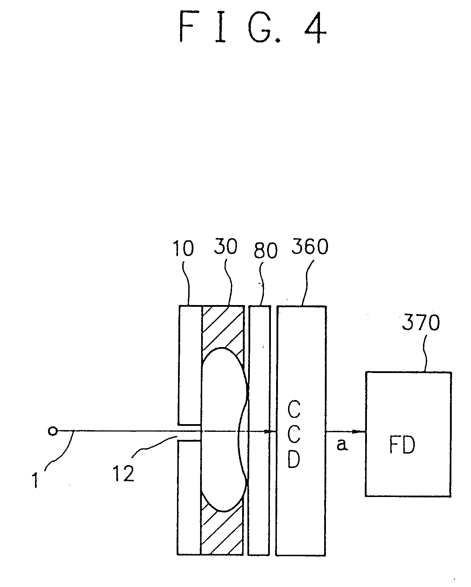

Fig. 4 shows in a schematic diagram an alternative embodiment of a compact camera in accordance with the present invention. As compared with Fig. 3 showing a white-and-black camera, Fig. 4 shows the constitution of a camera to produce a color picture. In the color camera, there are included a planar body 10 having a pinhole 12 disposed therein, an aspherical lens 20, and a color filter 80 following the lens 20.

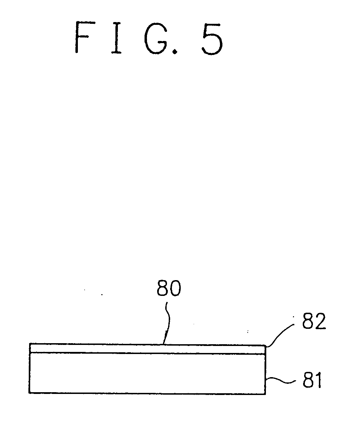

Generally, in a color camera, the refractive index varies between three primary colors. To prevent color shading for a high-quality picture reproducibility, it is necessary to arrange a color filter 80 between the lens and the charge-coupled device. As shown in Fig. 5, the color filter 80 is formed by a MgF₂ coating layer 82 on the IR glass 81. The thickness of the IR glass 81 and the coating layer 82 are for example 1.6 mm and 0.003 mm, respectively.

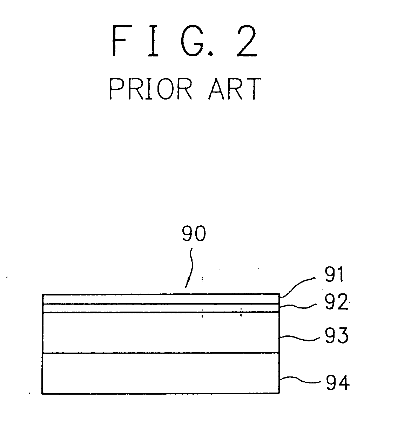

As shown in Fig. 2, a conventional color filter 90 is formed with birefringence plate 91 and 92 having the thickness of 0.58 mm, IR glass having the thickness of 1.6 mm, and birefringence plate 94 having the thickness of 1.63 mm. As a result, the whole thickness is for example 4.39 mm. Consequently, also when such a color filter is used in a camera having a pinhole like in the case of the present invention, the thickness of the camera becomes greater due to that of the color filter.

In contrast thereto, the color filter 80 in accordance with the present invention is manufactured by only the IR glass 81 and the coating layer 82 and the thickness is only 1.6 mm. As a result, when compared with the conventional color filter, a much thinner color filter can be obtained, hence the minimization of thickness of the camera.

An optical camera shown in each of the embodiments is configured by a pinhole and a lens attached to the pinhole, hence the minimization of thickness of the camera. Therefore, a miniaturization of the camera can be realized. Further, the lens structure is simple, so that the camera is inexpensive.

Moreover, the camera of this kind is suitably applicable to various uses, for example, as a monitoring camera for monitoring a cash dispenser to prevent crime and a video conference camera disposed on a table for attendants of a conference. Particularly, the lens is not exposed on the front side of the camera and the thickness of the camera is quite small. Consequently, when used as a hidden camera to monitor persons, the camera can accomplish the monitoring operation while being concealed from view.

Furthermore, the electric signal a obtained from the CCD 360 is inputted to an image input terminal of a computer so that the inputted electric signal a can be used for inputting image data to the computer. Moreover, the above-described camera can be disposed on a telephone so as to transmit the electric signal a outputted from the CCD 360 through a telephone communication network for, use in the imaging of visual telephone.

In the description of the embodiments, the present invention is applied to an electronic still camera in which an object is shot so as to obtain and to record a picture thereof on a floppy disk. However, the present invention is naturally applicable to a camera producing an image on a silver-halide photographic film.

As above, according to the camera of the present invention, the proceeding and succeeding groups of lenses employed in the conventional camera become unnecessitated. Namely, arranging only a planar body having a pinhole therein and an aspherical lens, there can be obtained a clear picture without distortion. In consequence, the camera is produced in quite a simplified structure with a thin and compact shape. Moreover, the price thereof can be lowered. Therefore, the camera can be applied to a various kinds of uses. In addition, since the lens is concealed from view on the front, side of the camera, there can be suitably achieved a monitoring operation with the camera.

While the present invention has been described with reference to the particular illustrative embodiments, it is not to be restricted by those embodiments but only by the appended claims. It is to be appreciated that those skilled in the art can change or modify the embodiments without departing from the scope and spirit of the present invention.

## Claims

1. A camera comprising:
a planar body (10) having a pinhole therein: and
a lens (20) arranged to be brought into contact with the planar body.

2. A camera as claimed in claim 1, wherein the lens (20) is an aspherical lens.

3. A camera as claimed in claim 1, wherein the camera is a color camera further including a color filter (80) disposed on a rear side of the aspherical lens, the filter being manufactured through a MgF₂ coating process on an IR glass.

4. A camera as claimed in claim 1, further including imaging means (360) for receiving a light passed through the pinhole and the aspherical lens and producing therefrom a video signal.

5. A camera as claimed in claim 4, wherein the video signal produced from the imaging means is supplied and inputted to a computer or devices (370) near the computer.

6. A camera as claimed in claim 4, wherein the video signal produced from the imaging means is inputted to a telephone and transmitted through a communication network therefrom.

7. A camera as claimed in claim 1, the camera being a hidden camera.

8. A camera as claimed in claim 1, the camera being used as a monitoring camera for crime prevention.

9. A camera as claimed in claim 1, the camera being arranged on a conference table or on a monitor used for photographing a TV conference.

10. A camera comprising:
a planar body having, a pinhole therein through which light may pass; and
a lens disposed behind the planar body and through which light passes after passing through the pinhole.
